# EUROPEAN PATENT APPLICATION

(11) **EP 4 496 441 A1**
(43) Date of publication of application: **22.01.2025**
(21) Application number: 23185901.8
(22) Date of filing: 17.07.2023
(51) Int. Cl.: H05K 7/20, G06N 10/40, H01L 23/44, H10N 69/00

(54) **SYSTEM AND METHOD FOR OPERATING A SET OF QUBITS AT A CRYOGENIC OPERATING TEMPERATURE**

(71) Applicant: Nederlandse Organisatie voor toegepast-natuurwetenschappelijk Onderzoek TNO, 2595 DA 's-Gravenhage (NL)
(72) Inventor: VAN ZWET, Erwin John, 2595 DA 's-Gravenhage (NL)
(74) Representative: V.O.

(57) **Abstract**

A system (100) and method for operating a set of qubits (10q) at a cryogenic operating temperature (Tq) are provided. The system comprises a first substrate (10) and a second substrate (20) that are electrically interconnected by a set connectors (30). The first substrate (10) comprises the set of qubits (10q) and the second substrate (20) comprises electronics (21) configured to operate the set of qubits (10q). A first cooling element (41) keeps the first substrate (10) at a first cryogenic temperature (T1) below the cryogenic operating temperature (Tq), and a second cooling element (42) keeps the second substrate (20) at a second cryogenic temperature (T2) above the cryogenic operating temperature (Tq). The set of connectors (30) is configured to keep a heat flow between the second substrate (20) and the first substrate (10) below a threshold value sufficiently low to maintain the set of qubits (10q) at the cryogenic operating temperature (Tq).

## Description

### TECHNICAL FIELD AND BACKGROUND

The present disclosure relates to a system for operating a set of qubits at a cryogenic operating temperature.

The present disclosure further relates to a method for operating a set of qubits at a cryogenic operating temperature.

In physics, cryogenics is the production and behavior of materials at very low temperatures, i.e. according to a generally accepted definition temperatures below a threshold of 120 K (or -153 °C). Temperatures below this threshold can be achieved with specific cooling fluids such as helium, hydrogen, neon, nitrogen, oxygen, and normal air while common refrigerants like Freon and hydrocarbons have boiling points above 120K.

The vast majority of technologies for future quantum computers require that the qubits be cooled down to close to absolute zero. At these low temperatures, the cooling power is very low, which places an upper limit on scaling up the number of qubits. Accordingly there is a need for means that render possible an increase of cooling power.

### SUMMARY

According to a first aspect of the present disclosure an improved system is provided for operating a set of qubits at a cryogenic operating temperature. The improved system comprises a first substrate, a second substrate, a set of electrically conducting connectors and a cryogenic system. The first substrate comprises the set of qubits and the second substrate comprises electronics configured to generate and/or process electrical signals for the operation and/or readout of the set of qubits. The set of electrically conducting connectors is provided for transmitting electrical signals between the first substrate and the second substrate. The cryogenic system (40) comprises a first cooling element that is thermally connected to the first substrate and a second cooling element that is thermally connected to the second substrate.

The first cooling element that is thermally connected to the first substrate is configured to keep the first substrate at a first cryogenic temperature, that is at or below the cryogenic operating temperature of the set of qubits.

The second cooling element that is thermally connected to the second substrate is configured to keep the second substrate at a second cryogenic temperature that is higher than the first cryogenic temperature, and above the cryogenic operating temperature of the set of qubits.

The set of electrically conducting connectors, also denoted as "connectors" is configured to keep a heat flow between the second substrate at the second cryogenic temperature and the first substrate at the first cryogenic temperature below a threshold value, wherein the threshold value is sufficiently low to maintain the set of qubits at the cryogenic operating temperature.

In an embodiment the improved system comprises a temperature controller to set the first cryogenic temperature and the second cryogenic temperature, wherein the second cryogenic temperature is higher than the first cryogenic temperature by at least one degree Kelvin. Therewith the second substrate that comprises the electronics can be cooled in a relatively cost-efficient manner, while reducing the heat flow to the first substrate that comprises the set of qubits and therewith relaxing requirements to the cooling equipment for the first substrate, provided that the temperature difference between the second cryogenic temperature and the first cryogenic temperature is not too high, e.g. less than 10K, preferably less than 5K, e.g. in the order of 2-4 K.

The heat load to the first substrate that has to be drained by the first cooling element partly originates from the operation of the components in the first substrate and partly from a heat flow from the second substrate to the first substrate. In alternative examples a heat controller is absent. In one such example a difference between the second cryogenic temperature and the first cryogenic temperature is determined in that the second cooling element is thermally coupled to a cooling stage of a cryostat preceding a cooling stage to which the first cooling element is coupled.

Heat may originate in the first substrate as a result of absorbed light, interaction of microwaves and switching of components therein. In an embodiment this contribution is limited to at most 10 mW.

A transport of heat from the second substrate to the first substrate is mainly determined by heat conduction via the set of electrically conducting connectors. In an embodiment this contribution is limited to at most 5 mW. Heat transport by radiation is proportional to the fourth power of the temperature and therewith can be ignored for practical purposes.

In an embodiment the heat flow from the first substrate to the first cooling element is at least 15 mW.

Typically the set of electrically conducting connectors comprises some tens of electrically conducting connectors per unit cell in the first substrate. For example, the electrically conducting connectors are shaped cylindrically e.g. with a length and a diameter in the order of some tens of microns, e.g. 20 micron. Alternatively the electrically conducting connectors can be formed with an ellipsoid shape or be a hollow cylinder.

In an embodiment the set of electrically conducting connectors comprise a superconducting material. The low temperature prevailing between the first substrate and the second substrate enables selection from a wide range of materials for this purpose. Providing the set of electrically conducting connectors from a superconducting material has a three-fold advantage. Firstly, signal losses in the set of electrically conducting connectors is minimized. Secondly heat generation in the set of electrically conducting connectors is minimized. Moreover thermal conduction in the set of electrically conducting connectors is minimized. It is conjectured that this is the case because Cooper pairs are taken up for electrical conduction, and therewith less available for thermal conduction. Exemplary superconducting materials for this purpose are Nb3Sn or NbTi, having a thermal conduction of less than 0.1 Watt per meter per Kelvin. In some examples super conducting materials are also used in the first substrate to alleviate heat dissipation of electrical signals.

In an embodiment the set of qubits comprised in the first substrate is provided as a set of respective unit cells of an optical chip (wafer). By way of example, each optical unit cell comprises a respective one of the qubits, for example formed by a Colour Centre, e.g. SnV (Tin Vacancy), or other vacancy, e.g. NV (Nitrogen Vacancy), or formed from any of group IV, e.g. Si, Ge, Pb. Each optical unit cell further typically comprises an optical connection including an electrically controlled optical switch, for example an electrostatically controlled MEMS, that is controlled with a control signal from the second substrate provided via respective ones of the electrically conducting connectors. As another example each optical unit cell comprises a photon detector, e.g. an SNSPD (superconducting nanowire single photon detector). The detector can be readout by the second substrate via respective ones of the electrically conducting connectors. Another possible component of an optical unit cell is a microwave antenna which is controlled by the second substrate via respective ones of the electrically conducting connectors. In an example the microwave antenna is formed of a superconducting material to attenuate heat dissipation. Alternatively a microwave antenna for an optical unit cell may be provided in the first substrate, e.g. a CMOS wafer, provided that a gap between the first and the second substrate is sufficiently small.

In an embodiment the first substrate is coupled by an optical interconnect to a photon radiation source. The photon radiation source can be provided at a location remote from the first substrate, so as to minimize exposure to heat induced therein. Typically the optical interconnect is provided to send optical input signals to the optical unit cells and readout is performed with a respective photon detector in the optical unit cell that issues an electric detection signal. Alternatively, the optical interconnect is also used to receive optical signals from the first substrate. In an embodiment the optical interconnect comprises respective optical fibers for respective ones of the optical unit cells. Additionally or alternatively the optical interconnect comprises respective optical fibers for different functions. In some embodiments the first substrate comprises optical filters and/or optical switches to demultiplex an optical input provided via an optical fiber to optical output for one or more specific optical unit cells and/or one or more specific functions.

In an embodiment the second substrate comprises a CMOS (Complementary metal-oxide-semiconductor) chip / wafer. Typical components thereon are a function generator for driving respective microwave antennas and a controller for optical switches in the first substrate. Electronic circuitry for such components can be provided as cryo-CMOS circuitry. Typically an electrical interconnect is provided that is configured to electrically communicate with the second substrate for the purpose of controlling its operation or to exchange input data and output data. In an embodiment the electrical interconnect is a wire bond to a printed circuit board near the second substrate.

In an embodiment the first substrate is suspended above the second substrate, i.e. the first substrate and the second substrate face each other, for example at a distance in a range of 10 - 20 µm. The set of electrically conducting connectors have a corresponding length required to interconnect respective contacts of the first substrate with respective contacts of the second substrate. Electrical connectors of the set of electrically conducting connectors have a thickness in the same order of magnitude as their length. For example some electrical connectors have a length of 20 µm as well as a thickness of 20 µm. Dependent on the function of the electrical connector its thickness may be selected differently. For example electrical connectors for relatively high voltage low power signals, e.g. for the purpose of controlling a MEMS may be relatively thin, whereas electrical connectors for transmitting large currents may be relatively thick.

In some embodiments a pressuring structure is provided to press one or more components against each other so as to improve a thermal conduction between these components and/or to improve an electric contact. In an example the first cooling support and the second cooling support having the first substrate and the second substrate arranged between them are pressed against each other. Therewith heat transport from the first substrate to the first cooling support and heat transport from the second substrate to the second cooling support is improved. The pressure also contributes to the quality of the electric connections provided by the set of electrically conducting connectors. In a practical implementation the pressure is exerted by bolts and springs that connect the first cooling support and the second cooling support. Heat transport from the second cooling support to the first cooling support via the bolts is not desired and can be mitigated by providing the bolts of a thermally low-conductive material and/or by thermally insulating the bolts from one or more of the first cooling support and the second cooling support.

Each of the first and the second cooling support can be thermally connected to an respective appropriate cryogenic stage by a thermal connection means like a cold finger or a strap.

In an embodiment a third substrate, also referred to as interposer, is arranged between the first substrate and the second substrate. In this embodiment the set of electrically conducting connectors comprises a first set of connectors that extends between the first substrate and the second substrate, a second set of connectors that extends between the first substrate and the interposer and a third set of connectors that extends between the interposer and the second substrate. This embodiment allows that the second substrate and the interposer are each optimally designed for a specific purpose. In one example, the second substrate is dedicated to process low voltage (e.g. <5V), high frequency signals (e.g. > 1GHz), and the interposer is dedicated to process high voltage signals (e.g. > 40V). For example, the first substrate is a silicon based optical chip, the interposer is provided with high voltage cryo-CMOS technology and the second substrate is provided with low power high frequency cryo-CMOS technology. The interposer for example renders relatively high voltage signals to drive MEMS-based optical switches in the first substrate. The third set of connectors that extend between the interposer and the second substrate can be relatively thick, so as to contribute to a heat transport from the interposer via the second substrate to the second cooling support. Alternatively or additionally heat conducting members may be provided between the interposer and the second substrate and/or between provided between the interposer and the second cooling support.

In some embodiments a magnetic field generator is provided that is configured to apply a magnetic field to the set of qubits. This renders it possible to select implementation of the qubits from a relatively wide range of technology. For example this enables the implementation of the qubits as SnV. Various other implementations do not require the presence of a magnetic field.

According to a second aspect of the present disclosure an improved method is provided for operating a set of qubits at a cryogenic operating temperature. The improved method comprises:
providing a first substrate comprising the set of qubits;
providing a second substrate comprising electronics configured to generate and/or process electrical signals for the operation and/or readout of the set of qubits;
providing a set of electrically conducting connectors for transmitting the electrical signals between the first substrate and the second substrate;
thermally connecting a first cooling element of a cryogenic system to the first substrate and maintaining therewith the first substrate at a first cryogenic temperature that is at or below the cryogenic operating temperature of the set of qubits;
thermally connecting a second cooling element to the second substrate and maintaining therewith the second substrate at a second cryogenic temperature that is higher than the first cryogenic temperature, and above the cryogenic operating temperature of the set of qubits;
therewith configuring the set of electrically conducting connectors to keep a heat flow between the second substrate at the second cryogenic temperature and the first substrate at the first cryogenic temperature below a threshold value, wherein the threshold value is sufficiently low to maintain the set of qubits at the cryogenic operating temperature.

In embodiments of the improved method the first substrate is suspended in front of the second substrate while maintaining a gap between the first substrate and the second substrate that is bridged by the set of electrically conducting connectors. Therewith a heat flow from the second substrate to the first substrate other than via the connectors can be mitigated. At cryogenic operating temperatures a heat transfer by radiation, being proportional to the fourth power of temperature is negligible. If desired the gap may be evacuated to avoid any heat conduction via a medium therein.

In embodiments of the improved method a pressure is applied for one or more of pressing the first substrate to the first cooling element to improve a thermal contact between the first substrate and the first cooling element, pressing the second substrate to the second cooling element to improve a thermal contact between the second substrate and the second cooling element and pressing the first substrate to the second substrate to improve an electric contact of the electrically conducting connectors with the first substrate and the second substrate.

Some embodiments of the improved method further comprise arranging a third substrate (also denoted as interposer) between the first substrate and the second substrate,
providing a first set of connectors extending between the first substrate and the second substrate;
providing a second set of connectors extending between the first substrate and the third substrate;
providing a third set of connectors extending between the third substrate and the second substrate.

The inclusion of a third substrate provides additional degrees of freedom to optimize the thermal design:
- The overall distance between the first substrate and the second substrate, which is the main heat source is increased. This contributes to reducing the heat flow from the second substrate towards the first substrate.
- The third substrate (or any further additional substrates) provides a material interface having a "thermal interface resistance" that also reduces the heat flow.
- Provided that the power dissipation of the third substrate is small this involves the freedom to operate it near the temperature of the second substrate, near the temperature of the first substrate or at an intermediate temperature. This entails a freedom in the selection of materials for the connectors so as to be compatible with the production processes. For example the high temperature compatible connectors are manufactured before performing low temperature compatible manufacturing processes.

In these embodiments each of the second substrate and the third substrate can be dedicated to provide circuitry for specific functionalities.

For example the second substrate is dedicated to process low voltage (e.g. <5V), high frequency signals (e.g. > 1GHz), and the interposer is dedicated to process high voltage signals (e.g. > 40V) to drive MEMS-based optical switches in the first substrate.

### BRIEF DESCRIPTION OF DRAWINGS

These and other features, aspects, and advantages of the apparatus, systems and methods of the present disclosure will become better understood from the following description, appended claims, and accompanying drawing wherein:
FIG. 1 schematically shows an embodiment of the improved system for operating a set of qubits at a cryogenic operating temperature;
FIG. 2 and FIG. 3 show exemplary components of the system in further detail;
FIG. 3A shows an aspect of FIG. 3 in still further detail;
FIG. 3B shows another aspect of FIG. 3 in still further detail;
FIG. 4 illustrates results from an axisymmetrical thermal simulation;
FIG. 5 shows details of another embodiment of the improved system.

### DESCRIPTION OF EMBODIMENTS

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

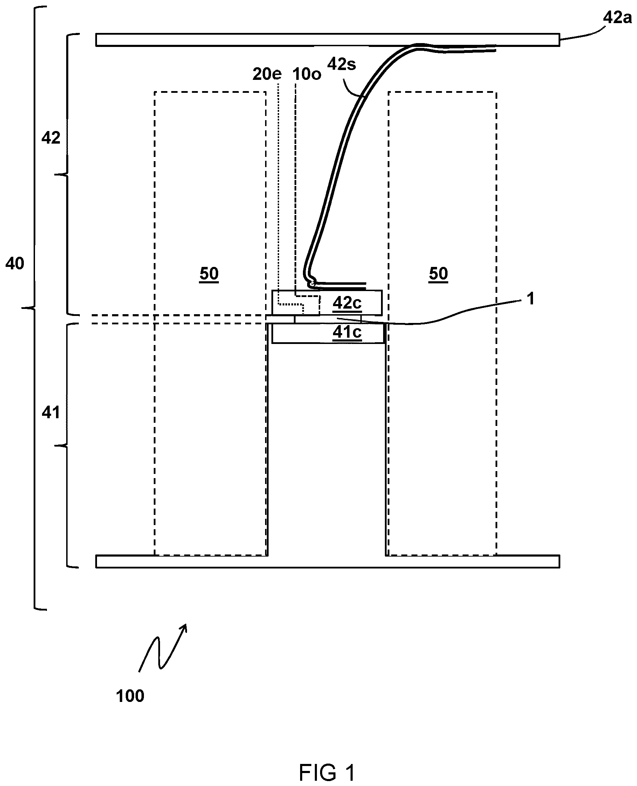

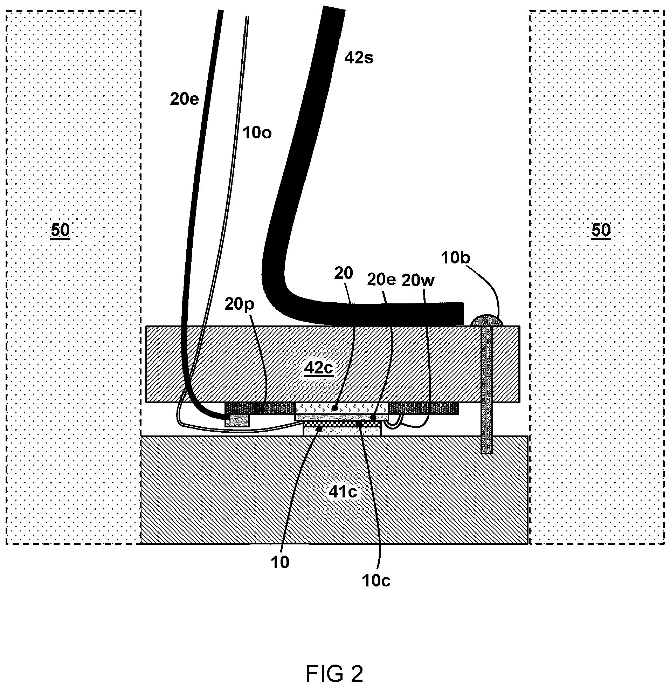

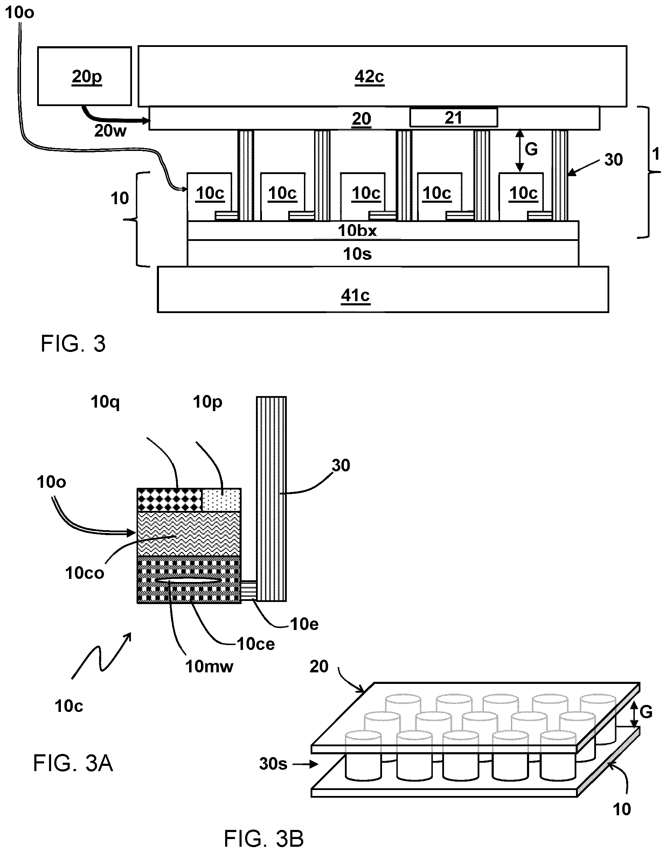

FIG. 1 schematically shows an embodiment of a system (100) for operating a set of qubits at a cryogenic operating temperature. The set of qubits is part of a composite processing unit 1. As shown in more detail in FIG. 2 and FIG. 3, the composite processing unit 1 comprises a first substrate 10 comprising the set of qubits 10q and a second substrate 20 that comprises electronics 21 configured to generate and/or process electrical signals for the operation and/or readout of the set of qubits 10q. As further shown in more detail in FIG. 3, a set of electrically conducting connectors 30, further also denoted as "connectors" is provided for transmitting the electrical signals between the first substrate 10 and the second substrate 20. Whereas for illustrative purposes only a few electrically conducting connectors are shown, in practice some tens of electrically conducting connectors may be provided for each qubit. The system 100 further comprises a cryogenic system 40 with a first cooling element 41 and a second cooling element 42. The first cooling element 41 comprising a first cooling support 41c that is thermally connected to the first substrate 10 and is configured to keep the first substrate 10 at a first cryogenic temperature T1 that is at or below the cryogenic operating temperature Tq of the set of qubits 10q. The second cooling element 42 comprising a second cooling support 42c is thermally connected to the second substrate 20 and configured to keep the second substrate 20 at a second cryogenic temperature T2 that is higher than the first cryogenic temperature T1, and above the cryogenic operating temperature Tq of the set of qubits 10q.

The set of electrically conducting connectors 30 is configured to keep a heat flow between the second substrate 20 at the second cryogenic temperature T2 and the first substrate 10 at the first cryogenic temperature T1 below a threshold value, wherein the threshold value is sufficiently low to maintain the set of qubits 10q at the cryogenic operating temperature Tq.

As visible in FIG. 1, 2, this embodiment of the system comprises a magnetic field generator 50 configured to apply a magnetic field to the set of qubits 10q. This renders possible a wide range of quantum computing approaches, for example also technologies based on SnV (tin vacancies). In some other quantum computing approaches a magnetic field generator 50 is not required.

As shown in more detail in FIG. 3, the first substrate 10 is suspended in front of the second substrate 20 while maintaining a gap G between the first substrate 10 and the second substrate 20. As shown further shown in in FIG. 3, the gap G is bridged by the set of electrically conducting connectors 30.

In the embodiment shown in FIG. 2 the first cooling support 41c of the first cooling element 41 and the second cooling support 42c of the second cooling element 42 are mechanically coupled by bolts 10b of which one is shown in the drawing. The bolts 10b exert a pressure between the first cooling support 41c and the second cooling support 42c. Therewith it is achieved that the first substrate 10 is clamped against the first cooling support 41c, which improves a thermal contact between the first substrate 10 and the first cooling support 41c. Likewise the second substrate 20 is clamped against the second cooling support 42c which improves a thermal contact between the second substrate 20 and the second cooling support 42c. Still further this results in a pressure between the first substrate 10 and the second substrate 20 which improves an electric contact of the electrically conducting connectors 30 with the first substrate 10 and the second substrate 20. A transport of heat from the second cooling support 42c to the first cooling support 41c can be minimized by providing the bolts 10b of a material with a thermally low conductivity and/or by thermally insulating the bolts from one or more of the first cooling support 41c and the second cooling support 42c. Alternative means may be provided instead to exert a pressure between the first cooling support 41c and the second cooling support 42c, for example a clamp holding the cooling supports. Additionally or alternatively a thermal contact between the first substrate 10 and the first cooling support 41c can be improved by a proper interface material, like indium or vacuum grease, between the first substrate 10 and the first cooling support 41c. Analogously, a thermal contact between the second substrate 20 and the second cooling support 42c can be improved in this manner.

FIG. 3 schematically shows a composite processing unit 1, comprising a first substrate 10 and a second substrate 20. As shown therein, the first substrate 10 comprises an optical chip with a plurality of optical unit cells 10c that each comprising a respective qubit 10q. Each optical unit cell 10c is electrically connected with a respective subset of the set of electrically conducting connectors 30 to electronic components of the second substrate 20.

An exemplary optical unit cell 10c is shown in more detail in FIG. 3A. As shown therein the exemplary optical unit cell 10c comprises in addition to the qubit 10q a respective single photon detector 10p that is configured to optically read out the qubit 10q. In example, the single photon detector 10p is a superconducting nanowire single photon detector (SNSPD). The exemplary optical unit cell 10c also comprises one or more optical components lOco for controlling optical communications between an optical interconnect 10o to an external photon radiation source (not shown) and the qubit 10q. The exemplary optical unit cell 10c further comprises electronic components 10ce for controlling optical components and electric connections 10e to electrically connect the single photon detector 10p and the electronic components 10ce with the set of electrically conducting connectors 30. By way of example the one or more optical components lOco comprise an electrically controlled optical switch, e.g. an electrostatically controlled MEMS that is operated by a MEMS drive signal from the second substrate 20 provided by respective ones of the set of electrically conducting connectors 30. Other examples of optical components that may be comprised in the one or more optical components lOco are an optical attenuator and an optical filter. The exemplary optical unit cell 10c further comprises a microwave antenna 10mw that is configured to subject the qubit 10q to a microwave field in response to a microwave drive signal supplied via respective ones of the set of electrically conducting connectors 30 by a microwave antenna driver in the second substrate 20. In other examples a microwave antenna 10mw for subjecting a qubit 10q to a microwave field is provided in the second substrate 20. In that case separate electrical connectors between the first substrate 10 and the second substrate 20 are not required for this purpose. Typically the first substrate 10 does not have electrically active components like transistors, to minimize power consumption therein.

In some examples the optical unit cells 10c each have a respective optical interconnect 10o. The respective optical interconnects 10o may be provided as a bundle to an external optical signal driver (not shown). In other examples two or more of the optical unit cells 10c share a common optical interconnect 10o the optical unit cells 10c comprise respective optical switches to selectively transmit optical signals intended for each optical unit cell 10c.

In the example shown in FIG. 3, the plurality of optical unit cells 10c is provided on a BOX layer (10bx), which in turn is provided on a Si handle wafer 10s. By way of example the Si-handle wafer has a thickness of a few hundred micron, e.g. 525 µm, the BOX-layer has a thickness in the range of a few micron to a few tens of microns, e.g. 3-20 µm and the optical unit cells are formed in a top layer having a thickness range of a single to a few tens of microns, e.g. 30 µm.

FIG. 3B shows an exemplary subset 30s of the set of electrically conducting connectors for a representative optical unit cell in the first substrate 10. By way of example the electrically conducting connectors are cylindrical elements with a length of 20 µm, a diameter of 20 µm of a super conducting material like NbTi. The electrically conducting connectors can be efficiently provided on the first substrate 10 in a lithographic process. Also other superconductor materials like Nb₃Sn are particularly suitable. Superconducting materials, provided that they are indeed in a superconducting state typically have a very low thermal conductivity as becomes apparent from the table below.

| Material | Tc (K) | Hc (T) | λ (W/m.K) |
|---|---|---|---|
| Metals | | | |
| Phosphor bronze | | | 1.6 |
| Manganin | | | 0.5 |
| Stainless steel | | | 0.27 |
| Nichrome | | | 0.25 |

| Specials | | | |
|---|---|---|---|
| Silver filled epoxy | | | 0.05 |
| Porous silicon | | | 0.04 |

| **Superconductors** | | | |
|---|---|---|---|
| Nb3Sn | 18 | 30 | 0.1 |
| NbTi | 10 | 15 | < 0.1 |

As becomes apparent, also other materials may be contemplated, that have a relatively low thermal conductivity (e.g not more than 0.5 W/m.K).

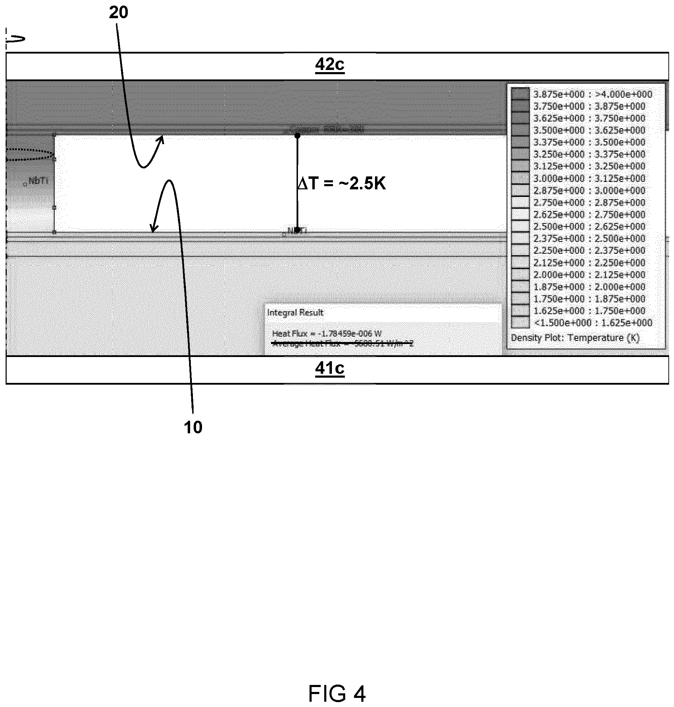

FIG. 4 illustrates results from an axisymmetrical thermal simulation. In this simulation it is presumed that the first cooling support 41c is maintained at a first cryogenic temperature T1 of 0.7 K and that the second cooling support 42c is maintained at a second cryogenic temperature T2 of 4K. It is further presumed that first substrate and the second substrate 20 are electrically interconnected by a total of 2800 set of cylindrical electrically conducting connectors 30 that each have a diameter of 20 µm (i.e. a cross-sectional area of about 314 µm²) as well as a length of 20 µm. The set of electrically conducting connectors 30 were simulated as being of the superconducting material NbTi, which has a thermal conductivity of less than 0.1 W/m.K. In this simulation the heat flow from the second substrate 20 via the set of electrically conducting connectors 30 to the first substrate 10 is about 5 mW. The heat production in the first substrate 10 itself is estimated to be about 10mW. Therewith the total heat flow to the first cooling support 41c is about 15 mW. In this simulation the first substrate 10 can operate at a cryogenic temperature of 1.5 K.

In a practical implementation the first cooling element 41 and the second cooling element 42 are provided by a Bluefors cryostat. In an embodiment thereof using He-3 as the cooling medium, it has a base temperature of 430 mK and it can provide a cooling power of 15 mW at the first cryogenic temperature T1 temperature of 0.7 K of the first cooling support 41c. It can provide a substantially larger cooling power of 1.85 W at the second cryogenic temperature T2 of 4 K at the second cooling support 42c, which is more than sufficient. Therewith the composite processing unit 1 can be sufficiently cooled in a cost efficient manner.

In an alternative embodiment He-4 is used as the cooling medium. This cooling medium provides for a slightly higher base temperature of 830 mK, but is obtainable at a lower cost.

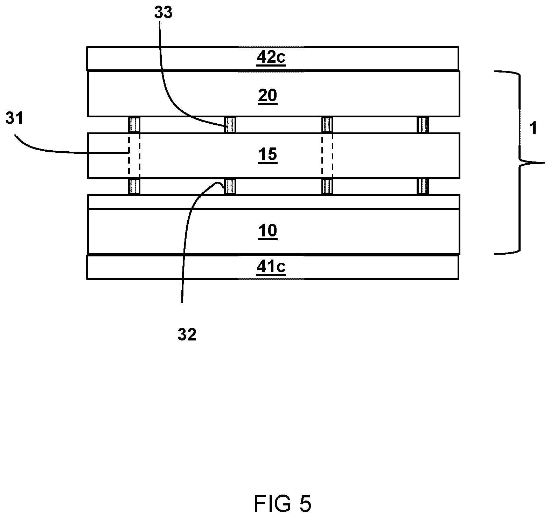

FIG. 5 shows an embodiment wherein the composite processing unit 1 comprises a third substrate 15, also referred to as interposer, that is arranged between the first substrate 10 and the second substrate 20. In this embodiment the set of electrically conducting connectors 30 comprises a first set of connectors 31 that extends between the first substrate 10 and the second substrate 20, a second set of connectors 32 that extends between the first substrate 10 and the interposer 15 and a third set of connectors 33 that extends between the interposer 15 and the second substrate 20. This embodiment allows that the second substrate 20 and the interposer 15 are each optimally designed for a specific purpose. In one example, the second substrate 20 is dedicated to process low voltage (e.g. <5V), high frequency signals (e.g. > 1GHz), and the interposer 15 is dedicated to process high voltage signals (e.g. > 40V).

For example, the first substrate is an optical chip, the interposer 15 is provided with high voltage cryo-CMOS technology and the second substrate 20 is provided with low power high frequency cryo-CMOS technology. The interposer 15 for example renders relatively high voltage signals to drive MEMS-based optical switches in the first substrate. The third set of connectors 33 that extend between the interposer 15 and the second substrate 20 can be relatively thick, so as to contribute to a heat transport from the interposer via the second substrate 20 to the second cooling support 42c. Alternatively or additionally heat conducting members may be provided between the interposer and the second substrate 20 and/or between provided between the interposer and the second cooling support 42c. The second set of connectors 32 that extends between the first substrate 10 and the interposer 15, provided to provide the high voltage drive signals for the MEMS-based optical switches can be relatively thin, which contributes to mitigating a heat transport from the third substrate 15 to the first substrate 10.

In summary, the present disclosure provides means for more efficiently operating a set of qubits 10q at a cryogenic operating temperature Tq. The means also comprise a method of operating a set of qubits 10q at a cryogenic operating temperature Tq that comprises providing a first substrate 10, providing a second substrate 20 and providing a set of electrically conducting connectors 30 for transmitting the electrical signals between the first substrate 10 and the second substrate 20. The first substrate 10 and the second substrate 20 can be provided in separate manufacturing processes. The first substrate 10 can be manufactured for example in an SOI process on a Silicon handle wafer provided with a box-layer. The process may comprise providing on the first substrate respective magnetic field generator coils and photonic circuitry comprising one or more of attenuators, optical switches, filters, waveguides and the like. In a pick and place process NV-centers can be positioned thereon to form qubits. Likewise a pick and place process can be applied to position respective photon detectors for readout of the qubits. The set of electrically conducting connectors 30 can be formed on the first substrate 10 in a lithographic process. The second substrate 20 that comprises electronics 21 configured to generate and/or process electrical signals for the operation and/or readout of the set of qubits 10q can be formed in a cryo-CMOS process on a silicon wafer, e.g. having a thickness of 500 µm. The electronics may typically comprise a function generator to provide drive signals for microwave antennas in the first substrate 10, drive signals for optical switches in the first substrate 10 and data processing circuitry to process photon detection signals from the photon detectors in the first substrate 10. Embodiments may further be conceived wherein the microwave antennas are accommodated in the second substrate 20 instead of in the first substrate 10. Also embodiments may be conceived wherein photon detectors are accommodated in the second substrate 20 instead of in the first substrate 10. In these embodiments the number of electrically conducting connectors 30 can be reduced, therewith mitigating heat transfer from the second substrate 20 to the first substrate 10.

The first substrate 10 and the second substrate 20 can be bonded upon completion of their manufacturing process, so that the set of electrically conducting connectors 30 is configured to transmit the electrical signals between the first substrate 10 and the second substrate 20. As an optional further step the first substrate 10 is electrically connected by wire bonds 20w to a printed circuit board 20p.

Subsequently, the first cooling element 41 of a cryogenic system 40 is thermally connected to the first substrate 10 to therewith maintain the first substrate 10 at a first cryogenic temperature T1 that is at or below the cryogenic operating temperature Tq of the set of qubits 10q. Likewise the second cooling element 42 is thermally connected to the second substrate 20 to maintain therewith the second substrate 20 at a second cryogenic temperature T2 that is higher than the first cryogenic temperature T1, and above the cryogenic operating temperature Tq of the set of qubits 10q. A thermal coupling between the first substrate 10 and the first cooling element 41 can be improved by using a thermal interface material between the first substrate 10 and a first cooling support 41c of the first cooling element 41. Analogously a thermal coupling between the second substrate 20 and the second cooling element 42 can be improved by using a thermal interface material between the second substrate 20 and a second cooling support 42c of the second cooling element 42. The first and the second cooling supports can be provided for example of copper or aluminum. In this method the set of electrically conducting connectors 30 is configured to keep a heat flow Fh between the second substrate 20 at the second cryogenic temperature T2 and the first substrate 10 at the first cryogenic temperature T1 below a threshold value, wherein the threshold value is sufficiently low to maintain the set of qubits 10q at the cryogenic operating temperature Tq.

Typically the first substrate 10 is suspended in front of the second substrate 20 while maintaining a gap between the first substrate 10 and the second substrate 20 that is bridged by the set of electrically conducting connectors to mitigate heat transfer from the second substrate to the first substrate.

In order to improve a thermal contact between the first substrate 10 and the first cooling element 41 these components may be pressed against each other. Likewise, the second substrate 20 and the second cooling element 42 may be pressed against each other to improve a thermal contact therebetween. Also the first substrate 10 and the second substrate 20 may be pressed to each other to improve an electric contact of the electrically conducting connectors 30 with electric terminals of these substrates. These objects of improving thermal contact and improving electric contact can simultaneously be achieved by pressing a first cooling support 41c towards a second cooling support 42c while the set of electrically conducting connectors 30 maintains a gap between the first substrate 10 and the second substrate 20.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. A system (100) for operating a set of qubits (10q) at a cryogenic operating temperature (Tq), the system comprising a first substrate (10) comprising the set of qubits (10q);
a second substrate (20) comprising electronics (21) configured to generate and/or process electrical signals for the operation and/or readout of the set of qubits (10q);
a set of electrically conducting connectors (30) for transmitting the electrical signals between the first substrate (10) and the second substrate (20);
a cryogenic system (40) comprising
a first cooling element (41) thermally connected to the first substrate (10) and configured to keep the first substrate (10) at a first cryogenic temperature (T1),
wherein the first cryogenic temperature (T1) is at or below the cryogenic operating temperature (Tq) of the set of qubits (10q);
a second cooling element (42) thermally connected to the second substrate (20) and configured to keep the second substrate (20) at a second cryogenic temperature (T2);
wherein the second cryogenic temperature (T2) is higher than the first cryogenic temperature (T1), and above the cryogenic operating temperature (Tq) of the set of qubits (10q);
wherein the set of electrically conducting connectors (30) is configured to keep a heat flow (Fh) between the second substrate (20) at the second cryogenic temperature (T2) and the first substrate (10) at the first cryogenic temperature (T1) below a threshold value, wherein the threshold value is sufficiently low to maintain the set of qubits (10q) at the cryogenic operating temperature (Tq).

2. The system according to claim 1, further comprising a temperature controller to set the first cryogenic temperature (T1) and the second cryogenic temperature (T2), wherein the second cryogenic temperature (T2) is higher than the first cryogenic temperature (T1) by at least one degree Kelvin.

3. The system according to claim 1 or 2, wherein the set of electrically conducting connectors are of a material having a thermal conduction of less than 2 Watt per meter per Kelvin.

4. The system according to claim 3, wherein the thermal conduction is less than 0.1 Watt per meter per Kelvin.

5. The system according to claim 3 or 4, wherein the material is a superconducting material.

6. The system according to claim 5, wherein the superconducting material comprises one or more of Nb₃Sn, NbN, TiN, MgB₂ or NbTi.

7. The system according to one of the preceding claims, wherein the first substrate (10) comprises an optical chip with a plurality of optical unit cells (10c), each comprising a respective qubit (10q).

8. The system according to claim 7, wherein each optical unit cell (10c) further comprises a respective single photon detector (10p) configured to optically read out the qubit (10q), an optical interconnect (10o), one or more optical components (lOco) for controlling optical communications between the optical connection and the qubit, electronic components (10ce) for controlling optical components and electric connections (10e) to electrically connect the single photon detector (10p) and the electronic components (10ce) with the set of electrically conducting connectors (30).

9. The system according to claim 7 or 8, wherein each optical unit cell (10c) further comprises a respective microwave antenna (10mw) configured to subject the qubit (10q) to a microwave field.

10. The system according to claim 7, 8 or 9, wherein the plurality of optical unit cells (10c) is provided on a BOX layer (10bx) (Buried Oxide, Silicon On Insulator).

11. The system according to claim 10, wherein the BOX layer is provided on a Si handle wafer (10s).

12. The system according to one or more of claim 8, 9, 10 and 11, wherein the optical interconnect (10o) is common to two or more of the optical unit cells (10c) and wherein respective ones of the two or more optical unit cells have a respective optical component to selectively transmit an optical signal to their respective qubit.

13. The system according to any of the preceding claims, wherein the set of electrically conducting connectors (30) between the first substrate (10) at the first cryogenic temperature (T1) and the second substrate (20) at the second cryogenic temperature (T2) provides a total thermal energy conduction less than 5 mW.

14. The system according to any of the preceding claims, wherein the heat flow from the first substrate (10) to the first cooling element (41) is at least 15 mW.

15. The system according to any of the preceding claims, comprising a third substrate (15) that is arranged between the first substrate (10) and the second substrate (20), and further:
a first set of connectors (31) that extends between the first substrate (10) and the second substrate (20);
a second set of connectors (32) that extends between the first substrate (10) and third substrate (15);
a third set of connectors (33) that extends between the third substrate (15) and the second substrate (20).

16. The system according to claim 15, wherein the second substrate (20) comprises circuitry for processing low voltage, high frequency signals, and the interposer (15) is dedicated to process high voltage signals.

17. A method of operating a set of qubits (10q) at a cryogenic operating temperature (Tq), the method comprising:
providing a first substrate (10) comprising the set of qubits (10q);
providing a second substrate (20) comprising electronics (21) configured to generate and/or process electrical signals for the operation and/or readout of the set of qubits (10q);
providing a set of electrically conducting connectors (30) for transmitting the electrical signals between the first substrate (10) and the second substrate (20);
thermally connecting a first cooling element (41) of a cryogenic system (40) to the first substrate (10) and maintaining therewith the first substrate (10) at a first cryogenic temperature (T1) that is at or below the cryogenic operating temperature (Tq) of the set of qubits (10q);
thermally connecting a second cooling element (42) to the second substrate (20) and maintaining therewith the second substrate (20) at a second cryogenic temperature (T2) that is higher than the first cryogenic temperature (T1), and above the cryogenic operating temperature (Tq) of the set of qubits (10q);
therewith configuring the set of electrically conducting connectors (30) to keep a heat flow (Fh) between the second substrate (20) at the second cryogenic temperature (T2) and the first substrate (10) at the first cryogenic temperature (T1) below a threshold value, wherein the threshold value is sufficiently low to maintain the set of qubits (10q) at the cryogenic operating temperature (Tq).
